# EUROPÄISCHE PATENTANMELDUNG

(11) **EP 3 929 324 A1**
(43) Veröffentlichungstag der Anmeldung: **29.12.2021**
(21) Anmeldenummer: 20182452.1
(22) Anmeldetag: 26.06.2020
(51) Int. Cl.: C23C 14/04, C23C 14/14, C23C 14/56

(54) **BESCHICHTUNGSVERFAHREN UND -VORRICHTUNG**

(71) Anmelder: Bühler Alzenau GmbH, 63755 Alzenau (DE)
(72) Erfinder: MÜCKE, Michael, 61206 Wöllstadt (DE)
(74) Vertreter: Vossius & Partner Patentanwälte Rechtsanwälte mbB

(57) **Zusammenfassung**

Die Erfindung stellt ein Verfahren und eine Vorrichtung zum Beschichten eines bandförmigen, flexiblen, dielektrischen Substrats mit einer metallischen Schicht auf einer Beschichtungsrolle, über die das Substrat während des Beschichtens entlang einer Längsrichtung des Substrats geführt wird, bereit. Zur Verbesserung der Haftung des Substrats auf der Beschichtungsrolle während des Beschichtens wird das Substrat aufgeladen. Das Substrat wird mit einer ersten metallischen Schicht beschichtet, wobei entlang der Längsrichtung des Substrats mindestens ein Freistreifen verbleibt, der nicht mit der metallischen Schicht beschichtet wird, und das beschichtete Substrats mit einer zweiten metallischen Schicht versehen.

## Beschreibung

Die vorliegende Erfindung betrifft ein Verfahren und eine Vorrichtung zum Beschichten von bandförmigen, flexiblen, dielektrischen Substraten, insbesondere zum mehrfachen Beschichten solcher Substrate.

Beim Beschichten bandförmiger Substrate, wie einer Folie, auf einer Beschichtungswalze ist es bekannt, das Substrat vor dem Beschichten mit Ladung zu versehen, um die Haftung des Substrats an der Beschichtungswalze zu verbessen. Das Aufladen des Substrats geschieht beispielsweise mit Hilfe eines Elektronenstrahls, der auf das Substrat vor dem Kontakt mit der Beschichtungswalze gerichtet wird. Die Ladung bewirkt eine starke Anhaftung des Substrats an der Walze, wodurch insbesondere die Kühlung des Substrats während der Beschichtungsvorgangs erheblich verbessert wird. Dadurch ist es möglich, die Beschichtungsrate zu erhöhen und/oder die Dicke des Substrats zu verringern. Ein solches Verfahren ist beispielsweise unter dem Namen SuperBias bekannt.

Die EP 1 686 197 B1 beschreibt ein Vakuumaufdampfungs-Ablagerungsverfahren und eine -vorrichtung, wobei die zu beschichtende Schicht aus isolierendem Material durch Aufladen in engen Kontakt mit einer Kühlwalze gebracht wird.

Das Aufladen des Substrats setzt ein dielektrisches Substrat voraus, leitende Substrate können durch den Elektronenstrahl nicht aufgeladen werden. Dies gilt auch für Substrate, die in einem vorangegangenen Schritt mit einer metallischen Beschichtung versehen worden sind. Auch eine solche Beschichtung bewirkt eine Leitfähigkeit eines eigentlich dielektrischen Substrats, was eine nachfolgende Aufladung nicht mehr erlaubt bzw. die Wirkung einer vorher durchgeführten Aufladung reduziert.

Aus diesem Grund können die Vorteile der bekannten Verfahren lediglich bei einer einmaligen, also auch nur einseitigen Beschichtung erzielt werden.

Es ist daher eine Aufgabe der Erfindung, die vorteilhaften Wirkungen einer Aufladung auch für Substrate zu erreichen, die in einem vorhergegangenen Prozessschritt metallisch beschichtet wurden. Dadurch soll insbesondere ermöglicht werden, den Beschichtungsvorgang auch für Prozesse zu verbessen, in denen ein Substrat mehrfach beschichtet wird, wobei zumindest einer der Beschichtungsvorgänge das Beschichten mit einer metallischen Beschichtung umfasst, wie mehrfachen oder auch doppelseitigen Beschichtungen. So soll eine Verbesserung auch für den einer metallischen Beschichtung folgenden Beschichtungsvorgang erreicht werden.

Diese Aufgaben werden mit den Merkmalen der Erfindung gemäß den unabhängigen Ansprüchen erreicht; die abhängigen Ansprüche definieren Ausführungsformen der Erfindung.

Es ist eine Grundidee der vorliegenden Erfindung, beim metallischen Beschichten eines Substrats das Substrat nicht über seine gesamte Breite zu beschichten, sondern zumindest einen Längsstreifen des Substrats vorzusehen, entlang dem keine Beschichtung erfolgt. Diese nicht mit einer metallischen Schicht versehenen Streifen des Substrats können dann die zuvor erfolgte Aufladung beibehalten bzw. neu mit Ladung versehen werden, so dass die Haftung des Substrats an der Beschichtungswalze zumindest entlang der freibleibenden Streifen verbessert bleibt. Die nachfolgende, weitere Beschichtung kann dann auf der gleichen Oberfläche oder der Rückseite erfolgen, vorzugsweise wieder in den bei der ersten Beschichtung beschichteten Abschnitten des Substrats.

Insbesondere stellt die Erfindung ein Verfahren zum Beschichten eines bandförmigen, flexiblen, dielektrischen Substrats mit einer metallischen Schicht auf einer Beschichtungsrolle, über die das Substrat während des Beschichtens entlang einer Längsrichtung des Substrats geführt wird, bereit. Zur Verbesserung der Haftung des Substrats auf der Beschichtungsrolle während des Beschichtens wird das Substrat aufgeladen. Das Substrat wird mit einer ersten metallischen Schicht beschichtet, wobei entlang der Längsrichtung des Substrats mindestens ein Freistreifen verbleibt, der nicht mit der metallischen Schicht beschichtet wird, und das beschichtete Substrats mit einer zweiten metallischen Schicht versehen. Der mindestens eine Freistreifen ist vorzugsweise in einer Umgebung zumindest einer Längskante des Substrats vorgesehen, wobei bevorzugt mindestens zwei Freistreifen verbleiben, wobei die beiden Längskanten des Substrats jeweils von einem der Freistreifen umfasst sind und die Freistreifen in Breitenrichtung um einen Abstand beabstandet sind, der in Längsrichtung des Substrats vorzugsweise konstant bleibt.

Vor dem Schritt (b) kann ein Schritt (a1) zum Behandeln der Abschnitte der zu beschichtenden Oberfläche des Substrats, an denen die Freistreifen verbleiben sollen, derart durchgeführt werden, dass das Auftragen der metallischen Schicht in den Freistreifen vermieden wird. Das Behandeln kann zumindest eines aufweisen, unter: Aufbringen von Öl oder anderer Medien, die im Vakuum nach einer gewissen Zeit verdampfen, mit einem Verdampfungsverfahren oder einem Offset-Druckverfahren; Abdecken mittels einer Maskierung; Einwirken einer Luftströmung zum Verblasen des Metalldampfes; Absaugen des Metalldampfes; Auftragen eines Schutzmediums; In-situ Verdampfen des Metallauftrags; und Schaffen von Bereichen stark verminderter Leitfähigkeit.

In Schritt (b) kann eine Oberfläche des Substrats beschichtet werden, wobei in Schritt (c) dieselbe Oberfläche des Substrats mit einer weiteren Schicht beschichtet wird. Auch kann in Schritt (b) eine Oberfläche des Substrats und in Schritt (c) die der in Schritt (b) beschichteten Oberfläche gegenüberliegende Oberfläche des Substrats beschichtet werden.

Vor dem Schritt (c) können Abschnitte der in Schritt (c) zu beschichtenden gegenüberliegenden Oberfläche des Substrats, an denen die Freistreifen verbleiben sollen, behandelt werden, um das Freibleiben der Freistreifen sicher zu stellen,
wobei bevorzugt die Freistreifen der gegenüberliegenden Oberfläche den in Schritt (b) verbliebenen Abschnitten der Oberfläche entsprechen.

Ferner kann die eine Oberfläche des Substrats und die der in Schritt (b) beschichteten Oberfläche gegenüberliegende Oberfläche des Substrats wechselseitig mit einer ersten und gegebenenfalls darauf folgende Schichten beschichtet werden.

Das Verfahren kann ferner das Beschichten des Substrats mit weiteren metallischen Schichten aufweisen.

Gegebenenfalls kann, zumindest vor einem der Schritte zum Beschichten des Substrats mit einer zweiten oder weiteren metallischen Schicht, ein Schritt zum erneuten Aufladen des Substrats durchgeführt werden.

Das Beschichten des Substrats erfolgt insbesondere mittels eines Vakuum-Aufdampfungsverfahrens.

Die Erfindung stellt ferner eine Vorrichtung zum Beschichten eines bandförmigen, flexiblen, dielektrischen Substrats mit einer metallischen Schicht auf einer Beschichtungsrolle, über die das Substrat während des Beschichtens entlang einer Längsrichtung des Substrats geführt wird, bereit. Die Vorrichtung weist auf:
eine Einrichtung zum Aufladen des Substrats zur Verbesserung der Haftung des Substrats auf der Beschichtungsrolle während des Beschichtens,
eine Einrichtung zum Beschichten des Substrats mit einer ersten metallischen Schicht,
wobei die Einrichtung derart konfiguriert ist, dass während des Beschichtens entlang der Längsrichtung des Substrats mindestens ein Freistreifen verbleibt, der nicht mir der metallischen Schicht beschichtet wird, und
eine Einrichtung zum Beschichten des beschichteten Substrats mit einer zweiten metallischen Schicht.

Die Vorrichtung kann ferner eine Einrichtung zum Aufbringen einer zweiten metallischen Schicht auf einer gegenüberliegenden Oberfläche des Substrates aufweisen.
Ferner kann eine Einrichtung zum Behandeln der Abschnitte der zu beschichtenden Oberfläche des Substrats, an denen die Freistreifen verbleiben sollen, derart vorgesehen sein, dass das Auftragen der metallischen Schicht in den Freistreifen vermieden wird.

Durch die vorliegende Erfindung kann der Vorteil einer Aufladung eines Substrats auch bei einem Beschichtungsvorgang des bereits mit einer metallischen Beschichtung versehenen Substrats erreicht werden.

Die vorliegende Erfindung wird im Folgenden anhand der Figuren näher erläutert; es zeigen
Fig. 1 schematisch eine Draufsicht und eine Seitenansicht eines durch das erfindungsgemäße Verfahren mit einer metallischen Schicht versehenen Bandsubstrats und
Fig. 2 eine Beschichtungswalze zur Illustration eines zweiten Beschichtungsvorgangs gemäß einer Ausführungsform der vorliegenden Erfindung.

Beim Beschichten, insbesondere bei Vakuumbeschichtungsvorgängen zum Beschichten von Folienbahnen in der Produktion von Elektronikbauteilen, wie beispielsweise beim Aufbringen von Aluminium- (Al-)Schichten bei Akku-Produktion, oder auch in der Verpackungsindustrie wird die zu beschichtende Folie (das Substrat) über Walzen geführt und die eigentliche Beschichtung beim Laufen der Folie über eine Beschichtungswalze durchgeführt. Beispielsweise kann die Beschichtung auf das Substrat durch Dampfabscheidungsverfahren oder Sputterverfahren aufgebracht werden.

So werden im Besonderen bei der Herstellung von Verpackungsfolien, aber auch von Kapazitäten oder Elektroden in der Akku-Produktion zunehmend dickere Metallschichten, insbesondere Al-Schichten, auf vergleichsweise dicken Substraten benötigt. Dementsprechend sollen auch bei diesen dickeren Schichten die Beschichtungszeiten nicht substantiell ansteigen. So ist es beispielsweise mit bisherigen Verfahren lediglich möglich, bei einer Schichtdicke von 50 nm Al Beschichtungsraten von höchstens ungefähr 10 m/s auf dem Bahnsubstrat zu erreichen. Jedoch gibt es gerade in der Batterie-Produktion bereits jetzt einen Bedarf nach Schichtdicken von 500 nm bis sogar 1,5 µm Al auf Folien mit einer Dicke von lediglich 8 µm, beispielsweise bei der Herstellung von Stromkollektoren. Dies ist mit bisherigen Vakuumbeschichtungsverfahren kaum zu realisieren. Durch die hohen Beschichtungsraten steigt die Kondensationswärme auf dem Substrat, wodurch der Wärmeeintrag auf das Substrat erhöht wird, der während der Beschichtung abgeführt werden muss. Somit werden Verfahren benötigt, die eine Erhöhung der Kühlungsmöglichkeiten der Beschichtungswalze erlauben.

Durch das Aufladen des Substrats vor dem Beschichten, beispielsweise durch Aufladen des Substrats mit einem Elektronenstrahl auf der der Walze abgewandten Seite, wird durch elektromagnetische Kraft die Haftung des Substrats an der Beschichtungswalze verbessert. Damit kann die während der Beschichtung entstehende Kondensationswärme besser über die Walze abgegeben werden.

Dies gelingt bei dielektrischen Substraten für einen ersten Beschichtungsvorgang erfolgreich. Allerdings ist es gerade bei den oben genannten Anwendungsfeldern oft notwendig, zwei oder mehrere Metallschichten auf das Substrat aufzubringen und/oder beide Seiten des Substrats mit einer Metallschicht zu versehen. Als Beispiel hierfür kann die Herstellung eines Kathoden/Anoden-Paars genannt werden. Ist aber eine Metallschicht auf das Substrat aufgetragen, hat das Substrat seine dielektrische Natur verloren und es ist nicht mehr möglich, Ladung auf das Substrat aufzubringen.

Um es zu erlauben, die Haftung auch bereits metallisierter Substrate an der Beschichtungswalze mittels der bereits für den ersten Beschichtungsvorgang verwendeten Ladeeinrichtung auch für eine weitere Beschichtung nutzen zu können, wird erfindungsgemäß während des Beschichtens mit der metallischen Schicht entlang der Längsrichtung des Substrats mindestens ein Freistreifen freigelassen. Die metallische Beschichtung wird also nicht über die gesamte Breite des Substrats aufgebracht, sondern entlang mindestens eines Streifens, bevorzugt von mindestens zwei oder mehr Streifen, so dass ein Bereich auf dem Substrat verbleibt, der die zuvor aufgebrachte Ladung erhalten kann und/oder auf den in einem weiteren Ladungsvorgang Ladung aufgebracht werden kann. Somit kann zumindest in den freibleibenden Streifen die Haftung an der Beschichtungswalze verbessert und damit der Wärmeübertrag auf die Walze sichergestellt werden.

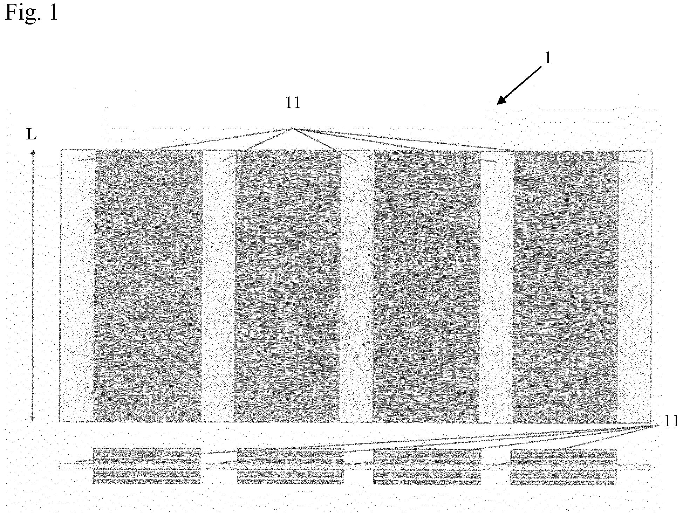

Ein entsprechend beschichtetes Substrat 1 ist schematisch in Fig. 1 in einer Draufsicht und einer Seitenansicht gezeigt. Entlang der Längsrichtung L des zu beschichtenden Substrats 1, das bahnförmig mit einer Länge von bis zu mehreren Kilometern bereitgestellt werden kann, werden Streifen 12 mit der Beschichtung versehen, während dazwischen liegende Streifen 11 frei bleiben (Freistreifen 11). Die frei bleibenden Streifen 11 bzw. Bereiche müssen einerseits breit genug sein, um eine ausreichende Haftung des teilweise metallisch beschichteten Substrats 1 sicher zu stellen; andererseits sollte die Breite der Streifen 11 so schmal wie möglich gewählt werden, da die frei bleibenden Bereiche später nicht für die Herstellung des gewünschten Produkts zu Verfügung stehen.

Um das Beschichten des Substrats in den gewünschten Bereichen zu vermeiden, können die entsprechenden Bereiche vor dem Beschichten behandelt werden. Beispielsweise kann im Bereich der nicht zu beschichtenden Streifen 11 vor dem Beschichtungsvorgang eine Ölschicht aufgetragen werden. Dies kann bevorzugt durch ein Offset-Druckverfahren durchgeführt werden. Auch ist der Einsatz eines Öl-Verdampfungsverfahrens, beispielsweise in Form eines Streifenölverdampfers möglich. Allgemein ist der Einsatz von Öl bevorzugt, da Öl (oder andere geeignete Kohlenwasserstoffe) im Vakuum nach einer gewissen Zeit verdampfen, ohne das Substrat zu schädigen. Solche Stoffe verdampfen bei der anschließenden Beschichtung im Vakuum und/oder durch Erhitzen der Grenzschicht während der Beschichtung.

An den Stellen, an denen die Ölschicht aufgebracht wurde, kann das Substrat nicht dauerhaft metallisch bedampft werden und vorher aufgebrachte Ladungen bleiben in diesen Bereichen erhalten. In einem nachfolgenden Beschichtungsvorgang halten diese Bereiche das Substrat an der Beschichtungswalze, trotz erfolgter metallischer Beschichtung in den übrigen Bereichen.

Andere Möglichkeiten, eine metallische Beschichtung lokal auf dem Substrat 1 zu verhindern, sind beispielsweise das Abdecken der entsprechenden Bereiche mittels einer Maskierung bzw. Auftragen eines Schutzmediums oder das gezielte Einwirken einer Luftströmung zum Verblasen oder Absaugen des Metalldampfs. Weiterhin kann eine bereits aufgebrachte Metallschicht auch gezielt in den entsprechenden Bereichen der frei zu haltenden Streifen 11 in-situ verdampft werden, beispielsweise durch Einwirkung einer lokalen Wärmequelle, wie eines IR-Lasers. Auch können vor dem Beschichten in den entsprechenden Streifen 11 Bereiche stark verminderter Leitfähigkeit geschaffen werden, in dem das Metall im Bereich der Freistreifen 11 reaktiv dielektrisch aufgetragen wird.

Das erfindungsgemäße Verfahren kann auch mehrfach hintereinander ausgeführt werden, wobei jeweils nach erfolgter lokaler Bearbeitung zur Verhinderung der Beschichtung und anschließender Beschichtung das Substrat wiederum, vorzugsweise in den gleichen Bereichen wie beim ersten Vorgang, lokal Bereiche vorgesehen werden, in denen die Beschichtung vermieden werden soll, und anschließend das Substrat wieder beschichtet wird. So kann also nicht nur die Beschichtung selbst mehrfach hintereinander erfolgen, sondern auch die zwischengeordneten Behandlungsschritte der nicht für die Beschichtung vorgesehenen Bereiche, wie beispielsweise der Ölauftrag durch einen Streifenölverdampfer.

Ferner kann die Beschichtungsvorrichtung, zum Beschichten von sowohl der Vorder- als auch der Rückseite eines Substrats in einem Arbeitsschritt auch eine weitere Einrichtung zum Aufbringen einer metallischen Schicht, also insbesondere eine zweite Beschichtungswalze und gegebenenfalls auch eine zweite Einrichtung zum Behandeln des Substrats auch auf der Rückseite zum Verhindern einer Beschichtung in den frei zu lassenden Bereichen.

Beispielsweise können bei einem Substrat von einer Breite von etwa 20 cm vier Streifen von jeweils etwa 3-4 cm aufgetragen werden, die jeweils von frei bleibenden Streifen von etwa 1 cm getrennt sind. Ebenso ist auch der Einsatz von Substraten möglich, die beispielsweise eine Breite von 600 bis 700 mm und eine Länge von 1,3 bis 1,7 m haben. Dies kann beispielsweise bei der Produktion von Batterien verwendet werden, die eine bestimmte Größe, z. B. etwa gleich der DIN A4- oder A5-Größe, haben sollen, wobei dann die Breite der Streifen entsprechend angepasst werden kann.

Vorzugsweise bleiben an den beiden Rändern entlang der Längsrichtung des Substrats 1 freie Streifen 11. Vorzugsweise ist das Streifenmuster auf dem Substrat symmetrisch ausgebildet. Auch kann das Substrat von beiden Seiten so behandelt werden, dass auf Vorder- und Rückseite die gleichen Bereiche von Beschichtung frei bleiben. Dies ist besonders bevorzugt in Fällen, in denen auf beiden Seiten des Substrats 1 eine Metallbeschichtung aufgetragen werden soll.

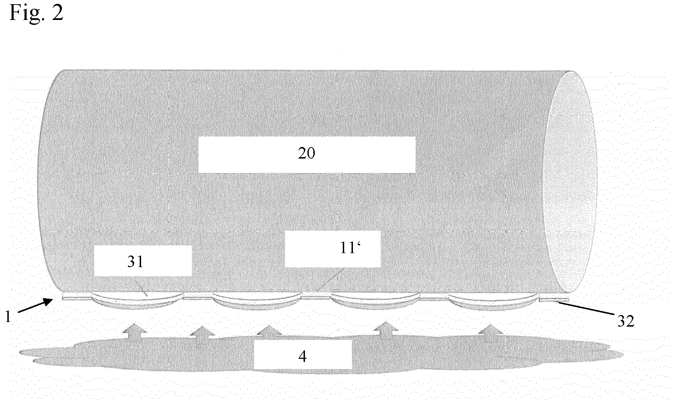

Hierdurch entstehen Bereiche, die trotz Wenden des Substrats 1 für beidseitige Beschichtung oder Mehrfachbeschichtungen beidseitig immer frei von metallischer Beschichtung gehalten werden. Diese Bereiche erhöhen, trotz Wenden, wiederholt die Anhaftung und schließen immer wieder Luftpolster ein, die eine optimale Kühlung aufrechterhalten, was nun mit Bezug auf Fig. 2 noch näher erläutert wird.

Fig. 2 zeigt schematisch eine Beschichtungswalze 20 über die ein bereits einmal mit einer Metallschicht in einem ersten Beschichtungsvorgang nach dem erfindungsgemäßen Verfahren beschichtetes Substrat 1 geführt wird. In den streifenförmigen Bereichen, in denen die Metallschicht aufgetragen ist, ist der Effekt einer Haftung des Substrats 1 an der Beschichtungswalze 20 durch die bereits vor der ersten Beschichtung oder auch neu, nach der ersten Beschichtung aufgebrachten Ladung nicht mehr gegeben. Vielmehr bilden sich in diesen Bereichen zwischen der Walze 20 und dem Substrat 1 Luftpolster 31 aus. Wie oben beschrieben unterstützen die so ausgebildeten Luftpolster 31 die Kühlung des Substrats 1. In diesen Bereichen kann durch ein geeignetes Verfahren ein gasförmiges Medium zur Verstärkung der Wirkung eines Gaspolsters eingebracht werden.

In den übrigen Bereichen 11' des Substrats 1 ist ein Ölfilm 32 aufgetragen worden, der eine Beschichtung des Substrats in diesen Bereichen 11' verhindert. Dort haftet das Substrat 1 an der Walze 20, so dass es in den Zwischenbereichen zur Ausbildung der Luftpolster/Gaspolster 31 kommen kann, um die Kühlung sicherzustellen und eine optimale Beschichtung aus dem in der Umgebung der Walze vorgesehenen Metalldampf 4 zu gewährleisten.

Mit der vorliegenden Erfindung wird also neben dem Verfahren auch eine entsprechende Vorrichtung zum Beschichten von Substraten mit einer Einrichtung zum Aufladen des Substrats, insbesondere mittels einem Elektronenstrahl, eine Einrichtung zum Behandeln des Substrats zum Sicherstellen, dass die gewünschten Freistreifen nicht beschichtet werden, beispielsweise eine Einrichtung zum lokalen Auftragen eines dünnen Ölfilms, und schließlich eine Einrichtung zum Beschichten des Substrats auf eine Oberfläche insbesondere mit einer Beschichtungswalze, beispielsweise eine Vakuum-Bedampfungsvorrichtung. Die Beschichtungseinrichtung, und gegebenenfalls auch die Einrichtung zum Aufladen und/oder zum Behandeln, kann dann, nach erfolgtem ersten Beschichten ein weiteres Mal unter Ausnutzung der Vorteile der unvollständigen metallischen Beschichtung für eine zweite und gegebenenfalls weiteren Beschichtungen auf der gleichen oder auch der gegenüberliegenden Seite verwendet werde oder es können, wie oben bereits angemerkt, jeweils zweite Einrichtungen vorgesehen sein, um eine erste und zweite Beschichtung in einem Prozessschritt, insbesondere auf Vorder- und Rückseite des Substrats, aufzutragen.

Obwohl die Erfindung mittels der Figuren und der zugehörigen Beschreibung dargestellt und detailliert beschrieben ist, sind diese Darstellung und diese detaillierte Beschreibung illustrativ und beispielhaft zu verstehen und nicht als die Erfindung einschränkend. Es versteht sich, dass Fachleute Änderungen und Abwandlungen machen können, ohne den Umfang der folgenden Ansprüche zu verlassen. Insbesondere umfasst die Erfindung ebenfalls Ausführungsformen mit jeglicher Kombination von Merkmalen, die vorstehend zu verschiedenen Aspekten und/oder Ausführungsformen genannt oder gezeigt sind.

Die Erfindung umfasst ebenfalls einzelne Merkmale in den Figuren, auch wenn sie dort im Zusammenhang mit anderen Merkmalen gezeigt sind und/oder vorstehend nicht genannt sind.

Weiterhin schließen die Ausdrücke "aufweisen", "umfassen" und Ableitungen davon andere Elemente oder Schritte nicht aus. Ebenfalls schließt der unbestimmte Artikel "ein" bzw. "eine" und Ableitungen davon eine Vielzahl nicht aus. Die Funktionen mehrerer in den Ansprüchen aufgeführter Merkmale können durch eine Einheit erfüllt sein. Die Begriffe "im Wesentlichen", "etwa", "ungefähr" und dergleichen in Verbindung mit einer Eigenschaft beziehungsweise einem Wert definieren insbesondere auch genau die Eigenschaft beziehungsweise genau den Wert. Alle Bezugszeichen in den Ansprüchen sind nicht als den Umfang der Ansprüche einschränkend zu verstehen.

## Patentansprüche

1. Verfahren zum Beschichten eines bandförmigen, flexiblen, dielektrischen Substrats (1) mit einer metallischen Schicht auf einer Beschichtungsrolle (20), über die das Substrat (1) während des Beschichtens entlang einer Längsrichtung (L) des Substrats (1) geführt wird, mit den Schritten:
(a) Aufladen des Substrats (1) zur Verbesserung der Haftung des Substrats (1) auf der Beschichtungsrolle (20) während des Beschichtens,
(b) Beschichten des Substrats (1) mit einer ersten metallischen Schicht,
wobei entlang der Längsrichtung (L) des Substrats (1) mindestens ein Freistreifen (11) verbleibt, der nicht mit der metallischen Schicht beschichtet wird,
(c) Beschichten des beschichteten Substrats mit einer zweiten metallischen Schicht.

2. Verfahren nach Anspruch 1, wobei der mindestens eine Freistreifen (11) in einer Umgebung zumindest einer Längskante des Substrats (1) vorgesehen ist.

3. Verfahren nach einem der vorstehenden Ansprüche, wobei mindestens zwei Freistreifen (11) verbleiben, wobei die beiden Längskanten des Substrats (1) jeweils von einem der Freistreifen umfasst sind und die Freistreifen in Breitenrichtung um einen Abstand beabstandet sind, der in Längsrichtung (L) des Substrats (1) vorzugsweise konstant bleibt.

4. Verfahren nach einem der vorstehenden Ansprüche, ferner mit einem vor dem Schritt (b) durchgeführten Schritt (a1) zum Behandeln der Abschnitte der zu beschichtenden Oberfläche des Substrats (1), an denen die Freistreifen (11) verbleiben sollen, derart, dass das Auftragen der metallischen Schicht in den Freistreifen (11) vermieden wird,
wobei das Behandeln vorzugsweise zumindest eines aufweist, unter:
Aufbringen von Öl oder anderer Medien, die im Vakuum nach einer gewissen Zeit verdampfen, mit einem Verdampfungsverfahren oder einem Offset-Druckverfahren;
Abdecken mittels einer Maskierung;
Einwirken einer Luftströmung zum Verblasen des Metalldampfes;
Absaugen des Metalldampfes;
Auftragen eines Schutzmediums;
In-situ Verdampfen des Metallauftrags;
und
Schaffen von Bereichen stark verminderter Leitfähigkeit.

5. Verfahren nach einem der vorstehenden Ansprüche, wobei in den Schritten (b) eine Oberfläche des Substrats (1) beschichtet wird und in Schritt (c) dieselbe Oberfläche des Substrats (1) mit einer weiteren Schicht beschichtet wird.

6. Verfahren nach einem Ansprüche 1 bis 4, wobei in den Schritten (b) eine Oberfläche des Substrats (1) beschichtet wird und in Schritt (c) die der in Schritt (b) beschichteten Oberfläche gegenüberliegende Oberfläche des Substrats (1) beschichtet wird.

7. Verfahren nach Anspruch 6, wobei vor dem Schritt (c) Abschnitte der in Schritt (c) zu beschichtenden gegenüberliegenden Oberfläche des Substrats, an denen die Freistreifen (11) verbleiben sollen, behandelt werden, um das Freibleiben der Freistreifen (11) sicher zu stellen,
wobei bevorzugt die Freistreifen (11) der gegenüberliegenden Oberfläche den in Schritt (b) verbliebenen Abschnitten der Oberfläche entsprechen.

8. Verfahren nach Anspruch 6 oder 7, wobei die eine Oberfläche des Substrats (1) und die der in Schritt (b) beschichteten Oberfläche gegenüberliegende Oberfläche des Substrats (1) wechselseitig mit einer ersten und gegebenenfalls darauf folgende Schichten beschichtet werden.

9. Verfahren nach einem der vorstehenden Ansprüche, wobei das Verfahren ferner das Beschichten des Substrats (1) mit weiteren metallischen Schichten aufweist.

10. Verfahren nach einem der vorstehenden Ansprüche, wobei das Verfahren zumindest vor einem der Schritte zum Beschichten des Substrats (1) mit einer zweiten oder weiteren metallischen Schicht einen Schritt zum erneuten Aufladen des Substrats (1) aufweist.

11. Verfahren nach einem der vorstehenden Ansprüche, wobei das Beschichten des Substrats (1) mittels eines Vakuum-Aufdampfungsverfahrens erfolgt.

12. Verfahren nach einem der vorstehenden Ansprüche, wobei sich beim Beschichten des beschichteten Substrats in Schritt (c) in Abschnitten der Oberfläche, in denen in Schritt (b) die erste metallische Schicht aufgebracht wurde, ein Luftpolster (31) zwischen der Beschichtungsrolle (20) und dem Substrat (1) ausbildet, wobei vorzugsweise in diesen Abschnitten ein gasförmiges Medium zur Verstärkung der Wirkung eines Gaspolsters eingebracht wird.

13. Vorrichtung zum Beschichten eines bandförmigen, flexiblen, dielektrischen Substrats (1) mit einer metallischen Schicht auf einer Beschichtungsrolle (20), über die das Substrat (1) während des Beschichtens entlang einer Längsrichtung (L) des Substrats (1) geführt wird, wobei die Vorrichtung aufweist:
(a) eine Einrichtung zum Aufladen des Substrats (1) zur Verbesserung der Haftung des Substrats (1) auf der Beschichtungsrolle (20) während des Beschichtens,
(b) eine Einrichtung zum Beschichten des Substrats (1) mit einer ersten metallischen Schicht, wobei die Einrichtung derart konfiguriert ist, dass während des Beschichtens entlang der Längsrichtung (L) des Substrats (1) mindestens ein Freistreifen (11) verbleibt, der nicht mir der metallischen Schicht beschichtet wird, und
(c) eine Einrichtung zum Beschichten des beschichteten Substrats mit einer zweiten metallischen Schicht.

14. Vorrichtung nach Anspruch 14, ferner mit einer Einrichtung zum Aufbringen einer zweiten metallischen Schicht auf einer gegenüberliegenden Oberfläche des Substrates (1).

15. Vorrichtung nach Anspruch 13 oder 14, ferner mit einer Einrichtung zum Behandeln der Abschnitte der zu beschichtenden Oberfläche des Substrats, an denen die Freistreifen (11) verbleiben sollen, derart, dass das Auftragen der metallischen Schicht in den Freistreifen (11) vermieden wird.
